Europäisches Patentamt

European Patent Office

Office européen des brevets

(11) Veröffentlichungsnummer : **0 002 185**
**B1**

(12) **EUROPÄISCHE PATENTSCHRIFT**

(45) Veröffentlichungstag der Patentschrift :
02.12.81

(21) Anmeldenummer : 78101133.3

(22) Anmeldetag : 13.10.78

(51) Int. Cl.³ : **H 01 L 21/60, H 01 L 21/88,
H 05 K 3/46**

(54) Verfahren zum Herstellen einer Verbindung zwischen zwei sich kreuzenden, auf der Oberfläche eines Substrats verlaufenden Leiterzügen.

(30) Priorität : 20.10.77 US 843901

(43) Veröffentlichungstag der Anmeldung :
13.06.79 (Patentblatt 79/12)

(45) Bekanntmachung des Hinweises auf die Patenterteilung : 02.12.81 Patentblatt 81/48

(84) Benannte Vertragsstaaten :
DE FR GB

(56) Entgegenhaltungen :
DE - A - 2 155 029
DE - A - 2 430 692
DE - A - 2 617 483
DE - B - 2 058 554

(73) Patentinhaber : International Business Machines Corporation

Armonk, N.Y. 10504 (US)

(72) Erfinder : Alcorn, George Edward
2363 Glade Bank Way
Reston Va. 22091 (US)
Erfinder : Hamaker, Raymond Weaver
1560 Welburn Avenue
Gilroy California 95020 (US)
Erfinder : Stephens, Geoffrey Brownell
1320 Yubinaranda Circle
Cary North Carolina 27511 (US)

(74) Vertreter : Gaugel, Heinz, Dipl.-Ing.
Schönaicher Strasse 220
D-7030 Böblingen (DE)

## Verfahren zum Herstellen einer Verbindung zwischen zwei sich kreuzenden, auf der Oberfläche eines Substrats verlaufenden Leiterzügen

Die Erfindung bezieht sich auf ein Verfahren zum Herstellen einer Verbindung zwischen zwei sich kreuzenden, auf der Oberfläche eines Substrats verlaufenden ersten und zweiten Leiterzügen, bei welchem auf die mit einer Isolierschicht bedeckte Oberfläche des Substrats eine erste Metallschicht aufgebracht wird und unter Verwendung dieser Metallschicht die in einer ersten Ebene liegenden ersten Leiterzüge erzeugt werden, auf diese Leiterzüge eine Verbindungsöffnungen enthaltende Isolierschicht aufgebracht und auf dieser Isolierschicht aus einer zweiten, die Verbindungsöffnungen ausfüllenden Metallschicht die in einer zweiten Ebene liegenden zweiten Leiterzüge gebildet werden.

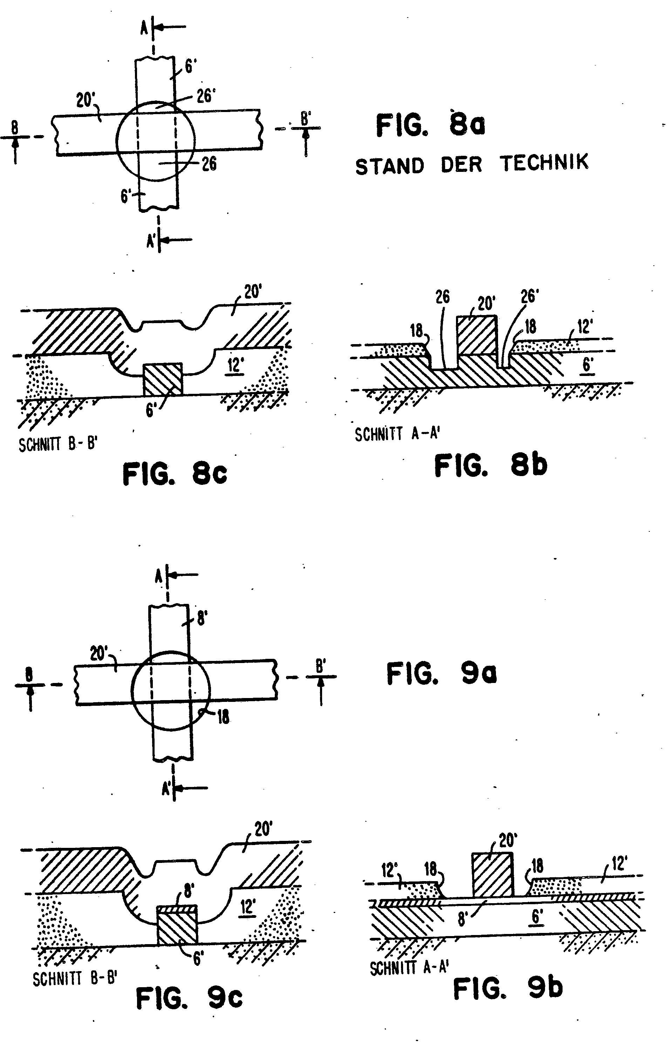

Mit der Zunahme der Packungsdichte von integrierten Schaltungen wurde es notwendig, die Verbindungsleiterzüge zwischen den einzelnen Transistorstrukturen auf einem Halbleiterplättchen in mehr als einer Ebene anzuordnen. In den Fign. 8a bis 8c ist ein Verbindungspunkt zwischen einem Leiterzug 6' in einer ersten Metallisierungsebene und einem Leiterzug 20' in einer zweiten Metallisierungsebene dargestellt. Die Verbindung wurde durch eine Öffnung in der die Leiterzüge trennenden Isolierschicht 12 hergestellt.

Bei den üblichen Verfahren zur Herstellung dieser Struktur wird zunächst auf ein Siliciumsubstrat 2 oder eine dieses bedeckende Siliciumdioxid-Schicht 4 eine erste Metallschicht 6 aus einer Legierung aus Aluminium, Kupfer und Silicium aufgebracht. Die metallischen Leiterzüge 6' werden sodann durch photolithographische Verfahren abgegrenzt. Die so erhaltene Anordnung der Leiterzüge der ersten Metallisierungsebene wird sodann mit einer Quarzschicht 12, die beispielsweise durch Kathodenzerstäubung aufgebracht wird, bedeckt. Diese Schicht dient als Isolierschicht zwischen den Leiterzügen der ersten und der zweiten Metallisierungsebene. Dannach wird in einem Bereich eines Leiterzuges 6' der ersten Metallisierungsebene, in welchem eine elektrische Verbindung zwischen der ersten Metallisierungsebene und den Leiterzügen der zweiten Metallisierungsebene vorgesehen ist, in der Quarzschicht 12 eine Verbindungsöffnung gebildet. Diesem folgt die Aufbringung einer Metallschicht 20 in der zweiten Metallisierungsebene. Einer der durch photolithographische Verfahren gebildeten Leiterzüge 20' der zweiten Metallisierungsebene liegt über der Verbindungsöffnung und stellt den gewünschten elektrischen Kontakt mit dem Leiterzug der ersten Metallisierungsebene her. Um eine hohe Packungsdichte zu erreichen, ist es erwünscht, daß die Leiterzüge der zweiten Metallisierungsebene so schmal sind, daß sie die Verbindungsöffnung nicht ganz überdecken. Dieses Erfordernis würde bedeuten, daß die zweiten Leiterzüge wesentlich breiter sind als die Verbindungsöffnung, um Ausrichtfehler und andere Verfahrenstoleranzen ausgleichen zu können. Zur Bildung der Leiterzüge der zweiten Metallisierungsebene wird üblicherweise entweder ein naßchemisches Ätzverfahren unter Zuhilfenahme von Phosphorsäure oder ein reaktives Ionenätzverfahren mit Kohlenstofftetrachlorid verwendet.

Bei diesen Herstellungsverfahren besteht jedoch das Problem, daß es keinen zuverläßigen Weg gibt, um die Leiterzüge 6' der ersten Metallisierungsebene beim Ätzen der Metallschicht 20 der zweiten Metallisierungsebene zu schützen. Infolge von Schwankungen in der Dicke der Metallschicht 20 der zweiten Metallisierungsebene innerhalb ihrer Toleranzen und von Schwankungen in der Ausrichtung und der Breite der Leiterzüge zwingen dazu, die Parameter des Verfahrens so festzusetzen, daß auch noch ein Leiterzug der größten Dicke, die wahrscheinlich auftreten wird, geätzt wird. Dadurch läßt es sich nicht vermeiden, daß bei dünnen Schichten der zweiten Metallisierungsebene die Leiterzüge 6' der ersten Metallisierungsebene überätzt werden, dargestellt in Fig. 8 beispielsweise bei 26 und 26'. Durch das Überätzen der Leiterzüge 6' erhalten diese an den Kreuzungspunkten einen geringeren Querschnitt und damit eine höhere Stromdichte. Hieraus entsteht ein Beitrag zu übermäßiger Wärmeerzeugung, Elektromigration und höherem Kontaktwiderstand infolge höherer Stromdichte. Alle diese Dinge tragen dazu bei, die Zuverlässigkeit und die Qualität der resultierenden integrierten Schaltung herabzusetzen.

Bei einem bekannten Verfahren dieser Art, daß in der DOS 24 30 692 beschrieben ist, wird eine Verbesserung der herzustellenden Verbindung dadurch angestrebt, daß zunächst die Leiterzüge der ersten Metallisierungsebene bedeckende Isolierschicht im Bereich der Kontaktstellen planarisiert wird. Dadurch soll ein Überätzen der Seitenkanten der Leiterzüge bei der Herstellung der Verbindunglöcher verhindert werden.

Bei einem anderen bekannten Verfahren dieser Art, das im IBM Technical Disclosure Bulletin, Vol. 19, Nr. 11, April 1977, Seiten 4152, 4153 beschrieben ist, werden die Leiterzüge der ersten Metallisierungsebene an den Kontaktstellen unterbrochen, um eine Erhöhung der Isolierschicht an den Kontaktstellen zu vermeiden und dadurch ein Überätzen bei der Herstellung der Verbindungslöcher zu unterbinden. Die Unterbrechung der Leiterzüge wird später durch das Aufbringen der Metallschicht der zweiten Metallisierungsebene wieder aufgefüllt.

Demgegenüber wird die Aufgabe der Erfindung darin gesehen, ein Verfahren anzugeben, durch welches beim Bilden der Leiterzüge der zweiten Metallisierungsebene ein Überätzen der Leiterzüge der ersten Metallisierungsebene verhindert wird. Auf diese Weise sollen dadurch, insbesondere bei Strukturen mit gegenüber dem Durchmesser der Verbindungslöcher schmalen Leiterzügen der zweiten Metallisierungsebene, zuverlässige Verbindungen hergestellt werden.

Gemäß der Erfindung, wie sie in den Ansprüchen gekennzeichnet ist, wird diese Aufgabe dadurch gelöst, daß auf die erste Metallschicht eine weitere Metallschicht aufgebracht wird, daß aus diesen beiden Metallschichten die ersten Leiterzüge gebildet werden, wobei die aus der weiteren Metallschicht erzeugten Teile der ersten Leiterzüge beim Ätzen der ersten Metallschicht als Ätzsperre dienen und daß die zweite Metallschicht zur Bildung der zweiten Leiterzüge unter Verwendung eines Ätzverfahrens geätzt wird, bei dem die die ersten und zweiten Leiterzüge trennende Isolierschicht nicht wesentlich angegriffen wird und bei dem die aus der weiteren Metallschicht gebildeten Teile der ersten Leiterzüge als Ätzsperre für die aus der ersten Metallischicht gebildeten Teile der ersten Leiterzüge dienen.

In vorteilhafter Weise wird auf die Metallschicht der ersten Metallisierungsebene als Ätzsperre eine Chromschicht aufgebracht. Als Isolierschicht zwischen den Metallisierungsebenen wird eine Quartzschicht aufgebracht, und das Ätzen der Leiterzüge der zweiten Metallisierungsebene erfolgt durch reaktives Ionenätzen, vorzugsweise mit einem Kohlenstofftetrachlorid-Argon-Gemisch bei einer Temperatur von mindestens 180 °C.

Das Ätzen der Leiterzüge der zweiten Metallisierungsebene kann auch durch naßchemisches Ätzen, vorzugsweise mittels einer Mischung aus Phosphorsäure und Salpetersäure durchgeführt werden. Den Stoffen zur Bildung der metallischen Schicht der ersten Metallisierungsebene wird Silicium beigegeben, während den Stoffen zur Bildung der metallischen Schicht der zweiten Metallisierungsebene kein Silicium beigegeben wird. Dabei dient die als Ätzschranke aufgebrachte Chromschicht als Diffusionssperre.

Der durch die Erfindung erreichte Vorteil besteht im wesentlichen darin, daß mit Hilfe der als Ätzschranke dienenden Chromschicht ein Überätzen der Leiterzüge der ersten Metallisierungsebene vermieden wird, und dadurch bessere Verbindungen hergestellt werden können. Gleichzeitig wird auch der Vorteil erreicht, daß die Chromschicht als Diffusionssperre für das Silicium dient, das, um ein Ausdiffundieren des Si aus dem Substrat zu verhindern, dem Metall der ersten Metallisierungsebene zugegeben werden muß, in der zweiten Metallisierungsebene dagegen unerwünscht ist.

Die Erfindung wird anhand eines durch die Zeichnungen erläuterten Ausführungsbeispieles beschrieben.

Es zeigen:

Fign. 1a bis 7a jeweils in Draufsicht, verschiedene Verfahrensstufen bei der Herstellung einer elektrischen Verbindung zwischen den Leiterzügen zweier Metallisierungsebenen,

Fign. 1b bis 7b die den Fign. 1a bis 7a entsprechenden Querschnitte entlang der Linie A-A',

Fign. 8a bis 8c eine nach bekanntem Verfahren hergestellte Struktur dieser Art, in Draufsicht und in Querschnitten entlang den Linien A-A' und B-B', und

Fign. 9a bis 9c in Anlehnung an die Darstellung der Fig. 8, eine nach den in den Fign. 1 bis 7 dargestellten Verfahren entstandene Struktur, in Draufsicht und in Querschnitten entlang den Linien A-A' und B-B'.

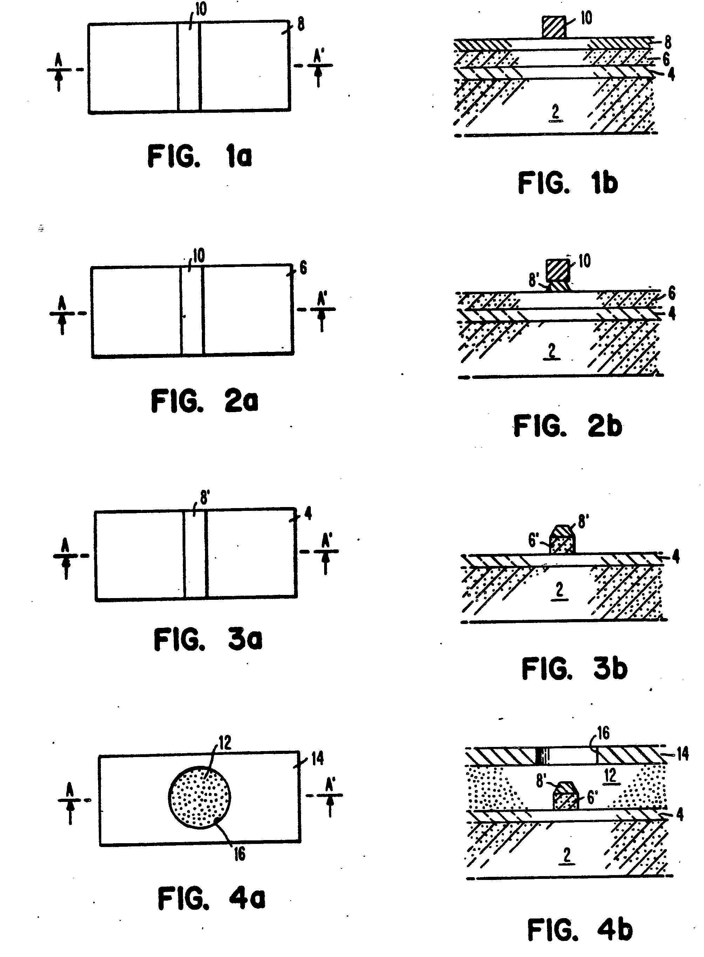

In den Fign. 1a bis 7a ist in Draufsicht eine Kreuzungstelle eines Leiterzuges einer ersten Metallisierungsebene mit einem Leiterzug einer zweiten Metallisierungsebene in verschiedenen Stufen des Herstellungsverfahrens dargestellt. Die Fign. 1b bis 7b stellen die den Strukturen der Fign. 1a bis 7a entsprechenden Querschnitte entlang der Linie A-A' dar.

Die Bezeichnung « nicht überlappende Anordnung einer Durchgangsöffnung » bedeutet bei einer zweilagigen Metallisierungsstruktur, daß in der zweiten Metallisierungsebene ein Leiterzug benutzt wird, dessen Breite kleiner oder gleich dem Durchmesser der Öffnung ist, welche er durchdringen muß, um Kontakt mit der ersten Metallisierungsebene herzustellen. Durch eine solche Struktur wird eine höhere Packungsdichte der metallischen Leiterzüge bei hochintegrierten, mikrominiaturisierten Schaltungen erreicht.

In den Fign. 1a und 1b ist die erste Stufe der Bildung einer elektrischen Verbindung zwischen zwei Metallisierungsebenen dargestellt. Auf der Oberfläche eines Siliciumsubstrats 2 ist eine SiO$_2$-Schicht 4 mit einer Dicke von 0,2 bis 0,5 μm aufgebracht. Anschließend wird in der ersten Metallisierungsebene eine 0,8 μm dicke Metallschicht 6, beispielsweise aus 95 % Aluminium, 4 % Kupfer und 1 % Silicium, aufgedampft.

Einen wesentlichen Bestandteil des hier beschriebenen Verfahrens bildet das Aufdampfen einer 0,2 μm dicken Chromschicht 8, die als Schranke für das Ätzen dient und die Metallschicht 6 während der nachfolgenden Verfahrenschritte schützt.

Dannach wird eine Photolackschicht 10 in Form eines Musters aufgebracht, durch welche die Linienführung der Metallschicht der ersten Ebene in der Schicht 8 festgelegt wird. Die nächste Stufe bei der Bildung der elektrischen Verbindung zwischen den Beiden Metallisierungsebenen ist in den Fign. 2a und 2b dargestellt. Dabei wird in einer Plasma-Ätzkammer, in welcher bei einem Druck von ungefähr 1,33 mbar ein aus CF$_4$ + 10 % O$_2$ bestehendes Plasma aufrechterhalten wird, aus der Chromschicht 8 ein Chromstreifen 8', der die Form des Leiterzuges besitzt, herausgeätzt.

In der nächsten Stufe, die in den Fign. 3a und 3b dargestellt ist, wird die aus einer Aluminium-Kupfer-Silicium-Legierung gebildete Schicht 6 zur Festlegung des Verlaufs des Leiterzuges 6' in der ersten Metallisierungsebene geätzt. Dies geschieht durch reaktives Ionenätzen unter Verwendung von Kohlenstofftetrachlorid + Argon (40-60 Mischung) bei einer über 180 °C liegenden Temperatur, wobei das Werkstück auf einem Potential von − 200 V gehalten wird. Dannach wird in einem Veraschungsverfahren unter Verwendung eines Hochfrequenzplasmas von 20 % O$_2$ und 80 % N$_2$ bei einem Druck von 1,33 mbar die gemusterte Photolackschicht 10 entfernt.

Im nächsten Schritt, der in den Fign. 4a und 4b dargestellt ist, wird eine 2,2 μm dicke, ebene Quarzschicht 12 über dem aus den Streifen 6′ und 8′ bestehenden Leiterzug der ersten Metallisierungsebene und um diesen herum aufgebracht. Darauf folgt die Bildung einer Photolackschicht 14, die nach dem vorgegebenen Muster eine Öffnung 16 an der Stelle über dem Leiterzug 6′ aufweist, an der die elektrische Durchgangsverbindung hergestellt werden soll.

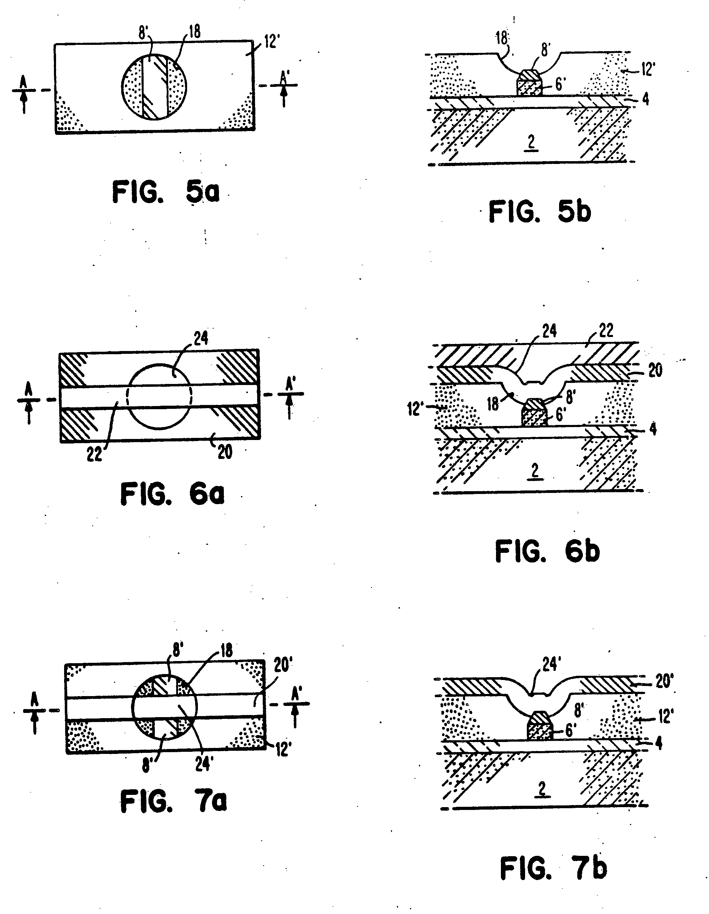

Als nächstes wird in die Quarzschicht 12 eine bis in die darunterliegende Schicht durchgehende Vertiefung 18 eingebracht (Fign. 5a und 5b). Dies geschieht durch Plasmaätzen mit einer Mischung aus Kohlenstofftetrafluorid CF$_4$ und 8 % Sauerstoff bei einem Druck von ungefähr 1,33 mbar. Dannach wird die Photolackschicht 14 entfernt.

In der nächsten, in den Fign. 6a und 6b dargestellten Stufe wird eine Schicht 20 aus einer Legierung von 95 % Aluminium und ungefähr 5 % Kupfer bis zu einer Dicke von 1,0 bis 1,2 μm auf der Oberfläche der strukturierten Quarzschicht 12′ aufgebracht. Die Schicht 20 folgt dabei der Oberfläche der Quarzschicht in der Öffnung 18 und bildet einen vertieften Bereich 24. Die Metallschicht 20 ist die zweite Lage der Metallisierung, aus der die oberen Leiterzüge der doppellagigen Struktur gewonnen werden. Auf ihrer Oberfläche wird eine Photolackschicht 22 in einem Muster aufgebracht. Dadurch wird ein Leiterzug 20′ der zweiten detaillisierungslage abgegrenzt, der den Leiterzug 6′ der ersten Metallisierungsebene in der Öffnung 18 schneidet.

Im nächsten, in den Fign. 7a und 7b dargestellten Verfahrensschritt wird der Leiterzug 20′ der zweiten Metallisierungsebene durch reaktives Ionenätzen mit einem Kohlenstofftetrachlorid-Argon-Gemisch bei einer Temperatur von mindestens 180 °C geätzt. Der Bereich 24′ des Leiterzuges 20′, der durch die Öffnung 18 hindurchgeht, stellt einen elektrischen und mechanischen Kontakt mit dem Leiterzug 6′, 8′ der ersten Metallisierungsebene dar. Unter der abdeckenden Wirkung der als Ätzsperre dienenden Chromschicht 8′ über dem aus einer Aluminium-Kupfer-Silicium-Legierung bestehenden Leiterzug 6′ der ersten Metallisierungsebene wird ein Überätzen des Leiterzuges 6′ beim reaktiven Ionenätzen vermieden, da die Ätzgeschwindigkeiten bei Chrom nur 1/6 der Ätzgeschwindigkeit bei der Al-Cu-Si-Legierung beträgt. Außerdem ist bei diesem Verfahren die Ätzgeschwindigkeit bei Quarz ungefähr 1/10 derjenigen bei der Al-Cu-Si-Legierung. Durch die Anordnung der Chromschicht 8′ wird der Leiterzug 6′ vor einem Angriff beim reaktiven Ionenätzen geschützt, und die exponierte Quarzschicht 12′ wird nur vernächlässigbar engegriffen. Der gebildete Leiterzug 6′ leidet damit nicht unter überätzen Bereichen mit verringerten Querschnitten, die zu einer Verschlechterung der Zuverlässigkeit und der elektrischen Eigenschaften führen.

In einer anderen Ausführungsform kann das reaktive Ionenätzen des Leiterzuges 20′ (Fign. 7a, 7b) durch ein Naßätzverfahren ersetzt werden. Beispielsweise kann zum Ätzen der Aluminium-Kupfer-Schicht 20′ eine Mischung aus Phosphorsäure und Salpetersäure verwendet werden. Diese Säure hat eine wesentlich reduzierte Ätzgeschwindigkeit bei Chrom. Somit wirkt auch bei diesem Naßätzen die Chromschutzschicht 8′ als Ätzsperre, die die darunterliegende Schicht 6′ beim Ätzen schützt.

Die Verwendung eines Naßätzverfahrens hat jedoch den Nachteil, daß dieses dazu neigt, das Aluminium-Kupfer-Silicium-Metall des Leiterzuges 6′ unter der schützenden Chromschicht 8′ zu unterschneiden, wodurch der stromleitende Querschnitt des Leiterzuges reduziert wird. In den Fällen, in denen ein derartig reduzierter Querschnitt in der ersten Metallisierungsebene toleriert werden kann, kann jedoch die Verwendung eines Naßätzverfahrens empfohlen werden.

Es wird darauf hingewiesen, daß die els Ätzsperre für den Leiterzug 6 wirkende Chromschicht 8′ zusätzlich den Vorteil bietet, daß durch sie die Breite des Leiterzuges mit größerer Zuverlässigkeit definiert wird. Die Chromschicht bildet eine Maske mit einer stabilen Querdimension während des Ätzens der Metallisierung in der ersten Ebene. Bei bekannten Verfahren, bei denen eine Photolackmaske zur Feststellung der Gestalt der Leiterzüge in der ersten Metallisierungsebene verwendet wird, hat die Maske die Tendenz, während des reaktiven Ionenätzens wegzuschmelzen. Dadurch entsteht ein abgeschrägter Verlauf der geätzten Seitenkanten der Leiterzüge. Dieses Problem wird durch die mechanische Stabilität der Chromschicht 8′ als Maske bei der Ionenätzung vermieden.

Die als Ätzsperre wirkende Schicht 8 kann außer Chrom auch aus anderen schwer schmelzbaren Metallen, wie Ti, Zr, V, Nb, Ta, W, Mo, Pt, Pd und Ni bestehen.

Wie bereits erwähnt, ist die erste Metallisierungschicht 6 mit Silicium gesättigt, um zu verhindern, daß Siliciumatome an den Kontaktstellen mit der Metallisierung 6 aus dem Substrat herausdiffundieren, wie es bei Schottky-Sperrdiodenkontakten oder bei flächen Emitterkontakten vorkommen kann. Wenn nun die zweite Metallisierung 20, die aus einer nicht mit Silicium gesättigten Legierung besteht, mit der ersten Metallisierung in Kontakt gebracht wird, kann bei den nachfolgenden Verfahrensschritten bei erhöhter Temperatur eine Diffusion der Siliciumatome aus der ersten Metallisierung 6 in die zweite Metallisierung 20 induziert werden. Dadurch wird die Silicium-Konzentration in der Metallschicht 6 reduziert und eine unerwünschte Diffusion von Silicium-Atomen aus dem Substrat in die Metallschicht 26 verursacht. Durch das Aufbringen der Chromschicht 8 entsprechend dem beschriebenen Verfahren, wird eine Diffusionsschranke erzeugt, die die unerwünschte Diffusion von Silicium-Atomen aus der Metallisierung 6 verhindert.

Die nunmehr entstandene Struktur ist in den Fign. 9a nis 9c in Anlehnung an die Darstellung des Standes der Technik in den Fign. 8a bis 8c nochmals, in einer Draufsicht und in zwei zueinander senkrechten Querschnitten entlang den Linien A-A' und B-B' dargestellt.

**Ansprüche**

1. Verfahren zum Herstellen einer Verbindung zwischen sich kreuzenden, auf der Oberfläche eines Substrats verlaufenden ersten und zweiten Leiterzügen, bei welchem auf die mit einer Isolierschicht bedeckte Oberfläche des Substrats eine erste Metallschicht (6) aufgebracht wird und unter Verwendung dieser Metallschicht die in einer ersten Ebene liegenden ersten Leiterzüge (6') erzeugt werden, auf diese Leiterzüge eine Verbindungsöffnungen (18) enthaltende Isolierschicht (12') aufgebracht und auf dieser Isolierschicht aus einer zweiten, die Verbindungsöffnungen ausfüllenden Metallschicht (20), die in einer zweiten Ebene liegenden zweiten Leiterzüge (20') gebildet werden, dadurch gekennzeichnet, daß auf die erste Metallschicht (6) eine weitere Metallschicht (8) aufgebracht wird, daß aus diesen beiden Metallschichten (6, 8) die ersten Leiterzüge (6', 8') geätzt werden, wobei die aus der weiteren Metallschicht (8) erzeugten Teile (8') der ersten Leiterzüge beim Ätzen der ersten Metallschicht als Ätzsperre dienen und daß die zweite Metallschicht (20) zur Bildung der zweiten Leiterzüge (20') unter Verwendung eines Ätzverfahrens geätzt wird, bei dem die die ersten und zweiten Leiterzüge trennende Isolierschicht (12') nicht wesentlich angegriffen wird und bei dem die aus der weiteren Metallschicht (8) gebildeten Teile (8') der ersten Leiterzüge als Ätzsperre für die aus der ersten Metallschicht (6) gebildeten Teile (6') der ersten Leiterzüge dienen.

2. Verfahren nach Anspruch 1, dadurch gekennzeichnet, daß auf die Metallschicht (6) der ersten Metallisierungsebene als Ätzsperre eine Chromschicht (8) aufgebracht wird.

3. Verfahren nach den Ansprüchen 1 oder 2, dadurch gekennzeichnet, daß als Isolierschicht (12) zwischen den Metallisierungsebenen eine Quarzschicht aufgebracht wird, und daß das Ätzen der Leiterzüge (20') der zweiten Metallisierungsebene durch reaktives Ionenätzen erfolgt.

4. Verfahren nach Anspruch 3, dadurch gekennzeichnet, daß das Ionenätzen des Leitungsmusters (20') der zweiten Metallisierungsebene mit einem Kohlenstofftetrachlorid-Argon-Gemisch bei einer Temperatur von mindestens 180 °C durchgeführt wird.

5. Verfahren nach den Ansprüchen 1 oder 2, dadurch gekennzeichnet, daß das Ätzen der Leiterzüge (20') der zweiten Metallisierungsebene durch naßchemisches Ätzen, vorzugsweise mitteis einer Mischung aus Phosphorsäure und Salpetersäure durchgeführt wird.

6. Verfahren nach einem oder mehreren der Ansprüche 1 bis 5, dadurch gekennzeichnet, daß den Stoffen zur Bildung der metallischen Schicht (6) der ersten Metallisierungsebene Silicium beigegeben wird, und daß den Stoffen zur Bildung der metallischen Schicht (20) der zweiten Metallisierungsebene kein Silicium beigegeben wird, wobei die als Ätzschranke aufgebrachte Schicht (8) als Diffusionssperre dient.

**Claims**

1. A process for forming an interconnection structure between intersecting first and second level metal lines extending across the surface of a substrate, wherein a first level metal layer (6) is applied to the surface of the substrate covered with an insulating layer and the first level lines (6') disposed in a first plane are generated, utilizing said metal layer, an insulating layer (12') including via holes (18) is applied to said lines, and second level lines (20') disposed in a second plane are formed on said insulating layer from a second metal layer (20) filling said via holes, characterized in that a further metal layer (8) is applied to said first metal layer (6), that said first level lines (6', 8') are etched from said two metal layers (6, 8), wherein the parts (8') of said first lines generated from said further metal layer (8) serve as an etch stop during the etching of said first metal layer, and that said second metal layer (20) is etched to form said second level lines (20'), using an etching technique whereby said insulating layer (12') separating said first and second level lines is not substantially attacked and whereby said parts (8') of said first level lines etched from said further metal layer (8) serve as an etch stop for the parts (6') of said first level lines formed from said first metal layer (6).

2. The process according to claim 1, characterized in that a chromium layer (8) is applied as an etch stop to said metal layer (6) of said first metallization plane.

3. The process according to claim 1 or 2, characterized in that a quartz layer is applied as an insulating layer (12) between said metallization planes, and that etching of said lines (20') of said second metallization plane is effected by reactive ion etching.

4. The process according to claim 3, characterized in that said line pattern (20') of said second metallization plane is ion-etched by means of a carbon tetrachloride argon mixture at a temperature of at least 180 °C.

5. The process according to claim 1 or 2, characterized in that said lines (20') of said second metallization plane are etched by wet etching, preferably using a mixture of phosphoric acid and nitric acid.

6. The process according to any one or combination of claims 1 to 5, characterized in that silicon is added to the materials used to form said metallic layer (6) of said first metallization plane, and that no silicon is added to the materials used to form said metallic layer (20) of said second metallization plane, wherein said layer (8) applied as an etch stop serves as a diffusion barrier.

## Revendications

1. Procédé pour interconnecter des premiers et seconds conducteurs croisés s'étendant sur la surface d'un substrat, dans lequel on dépose sur la surface d'un substrat recouverte d'une couche isolante, une première couche métallique (6) et on produit les premiers conducteurs (6') situés dans un premier plan à partir de cette couche métallique ; dans lequel on dépose sur ces conducteurs une couche isolante (12') comportant des ouvertures de traversée (18) et on forme sur cette couche isolante les seconds conducteurs (20') situés dans un second plan à partir d'une seconde couche métallique (20) remplissant les ouvertures de traversée ; procédé caractérisé en ce que l'on dépose sur la première couche métallique (6) une couche métallique supplémentaire (8), en ce que les premiers conducteurs (6', 8') sont décapés dans ces deux couches métalliques (6, 8), les parties (8') des premiers conducteurs formés à partir de la couche métallique supplémentaire (8), servant de barrières de décapage lors du décapage de la première couche métallique, et en ce que la seconde couche métallique (20) est décapée à l'aide d'un procédé de décapage pour former les seconds conducteurs (20') ; la couche isolante (12') séparant les premiers et seconds conducteurs n'étant pas substantiellement attaquée et les parties (8') des premiers conducteurs formés à partir de la couche supplémentaire métallique (8) servant de barrière de décapage pour les parties (6') des premiers conducteurs formés à partir de la première couche métallique (6).

2. Procédé selon la revendication 1, caractérisé en ce que l'on dépose sur la couche métallique (6) du premier plan de métallisation une couche de chrome (8) servant de barrière de décapage.

3. Procédé selon la revendication 1 ou 2, caractérisé en ce que l'on dépose entre les plans de métallisation une couche de quartz servant de couche isolante (12), et en ce que l'on décape les conducteurs (20') du second plan de métallisation par décapage ionique.

4. Procédé selon la revendication 3, caractérisé en ce que le décapage ionique de la configuration de conducteur (20') du second plan de métallisation utilise un mélange de tétrachlorure de carbone et d'argon à une température d'au moins 180 °C.

5. Procédé selon la revendication 1 ou 2, caractérisé en ce que l'on décape les conducteurs (20') du second plan de métallisation par un décapage chimique humide de préférence à l'aide d'un mélange d'acide phosphorique et d'acide nitrique.

6. Procédé selon l'une ou plusieurs des revendications 1 à 5, caractérisé en ce que l'on ajoute du silicium aux matériaux pour former la couche métallique (6) du premier plan de métallisation, et en ce que du silicium n'est pas ajouté aux matériaux pour former la couche métallique (20) du second plan de métallisation, la couche (8) déposée comme barrière de décapage servant de barrière de diffusion.

0 002 185

1/3

FIG. 1a

FIG. 1b

FIG. 2a

FIG. 2b

FIG. 3a

FIG. 3b

FIG. 4a

FIG. 4b

1

**FIG. 5a**

**FIG. 5b**

**FIG. 6a**

**FIG. 6b**

**FIG. 7a**

**FIG. 7b**

FIG. 8a

STAND DER TECHNIK

SCHNITT B-B'

FIG. 8c

SCHNITT A-A'

FIG. 8b

FIG. 9a

SCHNITT B-B'

FIG. 9c

SCHNITT A-A'

FIG. 9b